# EUROPEAN PATENT SPECIFICATION

(11) **EP 4 299 296 B1**
(45) Date of publication and mention of the grant of the patent: **20.05.2026**
(21) Application number: 22181288.6
(22) Date of filing: 27.06.2022
(51) Int. Cl.: B29C 70/88, B27N 3/00, B27N 3/04, B27N 3/18, B27N 7/00, B29C 70/54, B31F 1/00, B32B 37/16, D21F 11/00

(54) **ALTERNATIVE FOR FR-4 MATERIAL**
ALTERNATIVE FÜR FR-4-MATERIAL
MATÉRIAU FR-4 ALTERNATIF

(43) Date of publication of application: 03.01.2024
(73) Proprietor: PaperShell AB, 543 50 Tibro (SE)
(72) Inventor: BREITHOLTZ, Anders, 426 71 Västra Frölunda (SE); GUSTAFSSON, Mathieu, 126 39 Hägersten (SE)
(74) Representative: AWA Sweden AB

(56) References cited:
- EP-A1- 2 042 655
- WO-A1-2014/175196
- JP-A- 2013 035 969

## Description

### TECHNICAL FIELD

The present invention relates to a printed circuit board substrate comprising a sustainable composite material.

### BACKGROUND

Every electronic device includes one or more printed circuit boards ("PCBs"), which are relatively thin, layered substrates. These substrates comprise a plurality of electrically conductive and insulating layers upon which integrated circuits and other electronic components are mounted. The conductive layers generally have conductive paths or traces, which are chemically or mechanically etched out of the bulk conductive layer. They are therefore isolated from one another by the insulating material and routed within a plane. These traces are generally designed to electrically contact conductive portions of the electronic components mounted on the PCB, forming electrical connections. Electrical connections can also be formed between conductive layers by means of vias, which are essentially small, drilled, electrically conductive, holes that extend through two or more adjacent layers.

FR-4 (laminates of woven fiberglass reinforced with epoxy-like resin) is the material of choice for the insulating layers in PCBs used in high-end industrial, consumer, and military electronic equipment, due to its resistance to heat, mechanical shock, solvents and chemical substances. Further, the FR-4 material is flame resistant and self-extinguishing.

FR-4 epoxy resin systems typically employ bromine, a halogen, to induce flame-resistant properties. Flame-retardants (FR) are a group of anthropogenic environmental contaminants known for their negative impact on human health and the environment.

JP 2013035969 describes a method for producing a lignin derivative obtained by decomposing biomass. A resin board is also described, being manufactured by hardening the laminated body formed by laminating/stacking one sheet or more sheets of the prepregs comprising lignin derivative and a lignin secondary derivative. A prepreg is obtained by impregnating a lignin resin composition into a base material, such as kraft paper.

EP 2 042 655 describes a nanofiber sheet that sufficiently refined by fibrillation and has high crystallinity of cellulose fiber and can realize a fiber-reinforced composite material exhibiting high transparency, a high elastic modulus, a low coefficient of linear thermal expansion, and high heat resistance and being high in flatness and smoothness. This nanofiber sheet includes crystalline cellulose as the main component and a lignin in an amount of from 10 ppm to 10 wt%. When a fiber/resin composite material obtained by impregnating the nanofiber sheet with tricyclodecane dimethacrylate, subjecting the impregnated product to UV-curing at 20 J/cm 2 , and heating the cured product in vacuum at 160°C for two hours includes 60 wt% of the cured tricyclodecane dimethacrylate and 40 wt% of nanofiber, the following physical characteristics (i) to (iii) are satisfied: (i) the parallel light transmittance of light of a wavelength of 600 nm at a sheet thickness of 100 µm is 70% or more; (ii) the Young's modulus is 5.0 GPa or more; and (iii) the coefficient of linear thermal expansion is 20 ppm/K or less.

WO 2014/175196 discloses a solder-resist composition that exhibits good insulation performance and covering performance, being good at following the geometry of a formed circuit, wherein crack formation due to the heat of soldering is inhibited; and a printed circuit board using said solder-resist composition. A solder-resist composition contains a curable resin and cellulose nanofibers having a number-average diameter between 3 and 1,000 nm, inclusive.

The bromine substituent and its potential organobromide metabolites may increase the inherent toxicity of FR-4 materials. Thus, due to bromide(s) substituent(s), many brominated flame retardants are toxic (acute and chronic), persistent and bioaccumulate in the environment. The widespread use of brominated FR-4 materials as PCBs in electronics puts human health and the environment at risk.

Furthermore, in view of the growing awareness of the negative environmental impacts of global warming and pollution of sea and soil, it is a necessity to replace pure fossil-based plastics, and fiber reinforced plastics (FRP), such as glass fiber reinforced plastics (GFRP) as used in FR-4 epoxy resin systems, with more environmentally friendly alternatives.

The environmental impact of these materials is high in both manufacturing of raw materials like glass fiber, production of an intermediate of the same, and disposal and/or recycling. Attempts have been made to replace fossil-based polymers in GFRP materials with more environmentally friendly alternatives, e.g. bio based or bio attributed polymers. Further, attempts have been made to replace the glass or carbon fiber with natural fibers such as flax, hemp, sisal etc. However, the major challenge for both bio based and/or bio attributed, and renewable and/or natural fiber alternatives for GFRP composites is the lack of sufficient volumes and consistency of quality in supply that can compete with the fossil-based polymers and manmade fibers.

Considering the challenges currently existing in the technical field, it is desired to provide printed circuit board substrates, comprising sustainable and environmentally friendly material while obtaining mechanical properties being comparable to FR-4. Further, it is desirable to provide a process for obtaining such a printed circuit board substrate.

### SUMMARY

In view of the above, the present invention aims to solve at least some of the problems/gaps of the prior art. To this end, the present invention provides a printed circuit board (PCB) substrate which is based on renewable natural resources comprising at least one top and one bottom surface and a method of manufacturing such printed circuit board (PCB) substrate. The PCB substrate according to the present invention is defined in claim 1.

According to the invention, the binding agent is polyfurfuryl alcohol (PFA).

In one embodiment, the PCB substrate is provided, wherein said cellulosic fibers comprises from 0-100% virgin cellulosic fibers and 0-100% recycled cellulosic fibers.

In one embodiment, the PCB substrate is provided, wherein the at least one top surface and/or bottom surface has at least one developable and/or non-developable surface portion.

In one embodiment, a PCB substrate is provided, wherein said cellulosic fibers in said substrate are arranged substantially parallel, or wherein said cellulosic fibers in the substrate are arranged substantially crisscrossed, or wherein said cellulosic fibers in the substrate are arranged substantially random or arranged in a combination thereof.

In one embodiment, a PCB substrate is provided, wherein at least one conductive layer is adhered to the at least one top and/or at least bottom surface.

In one embodiment, a PCB substrate is provided, wherein the substrate comprises at least one cavity.

A printed circuit board (PCB) is provided comprising the substrate according to the present invention.

A PCB is provided, wherein the PCB is a single layer PCB, a double layer PCB or a multi-layer PCB.

Not according to the claimed invention, a method is provided for manufacturing a printed circuit board (PCB) substrate comprising at least one top surface and one bottom surface, the method comprising the steps of:
a) providing at least one sheet of cellulosic fibers having a maximum length of 10 mm;
b) impregnating the at least one sheet of cellulosic fibers with a mix of an acidic curing catalyst and a binding agent selected form the group consisting of: cellulose, hemicellulose, furan, lignin and combinations thereof, to obtain at least one impregnated sheet of cellulosic fibers;
c) pre-curing the at least one sheet of cellulosic fibers by applying heat in the range of 50 - 300°C, thus obtaining a prepreg;
d) arranging one or more prepregs in a stack;
e) pressing said stack in a pressing tool at a pressure of at least 7 kg/cm2, preferably at least 25 kg/cm2, more preferably at least 30 kg/cm2 and the temperature of at least 60°C, preferably at least 140°C, more preferably at least 150°C during a time period of at least 10 seconds, preferably at least one minute, more preferably at least two minutes, thus obtaining a PCB substrate with at least one top surface and one bottom surface.

The below embodiments related to the method are thus not according to the claimed invention.

In one embodiment, a method for manufacturing a PCB substrate is provided, wherein the binding agent is polyfurfuryl alcohol (PFA) .

In one embodiment, a method for manufacturing a PCB substrate is provided, wherein the cellulosic fibers comprise a mix of 0-100% virgin cellulosic and 0-100% recycled cellulosic fibers.

In one embodiment, a method for manufacturing a PCB substrate is provided, wherein the cellulosic fibers are provided in the form of paper.

In one embodiment, a method for manufacturing a PCB substrate is provided, wherein the surface has at least one developable and/or non-developable surface portion.

In one embodiment, a method for manufacturing a PCB substrate is provided, wherein the method comprises the optional step of cutting the prepreg and/or the PCB substrate in a pre-determined shape.

In one embodiment, a method for manufacturing a PCB substrate is provided, wherein said method further comprises step d') of arranging at least one conductive layer in said stack of prepregs, wherein step d') occurs simultaneously with or after step d) .

In one embodiment, a method for manufacturing a PCB substrate is provided, wherein said PCB substrate has an amount of biobased carbon of at least 80%.

In one embodiment, a method for manufacturing a PCB substrate is provided, wherein said PCB substrate comprises from 60 to 90 wt% of said cellulosic fibers.

In one embodiment, a method for manufacturing a PCB substrate is provided, wherein said PCB substrate comprises from 10 to 40 wt% of said binding agent.

In one embodiment, a method for manufacturing a PCB substrate is provided, wherein the prepregs in the stack are oriented such that the grain directions in the prepregs are substantially parallel.

In one embodiment, a method for manufacturing a PCB substrate is provided, wherein the prepregs in the stack are oriented such that the angle of the grain directions in the prepregs range from 0-90 with respect to the neighboring prepregs.

In one embodiment, a method for manufacturing a PCB substrate is provided, further comprising step f) of creating cavities in the PCB substrate.

Further features of, and advantages with, the present invention will become apparent when studying the appended claims and the following description. The skilled person realizes that different features of the present invention may be combined to create embodiments other than those described in the following, without departing from the scope of the present invention which is defined by the appended claims.

### BRIEF DESCRIPTION OF THE DRAWINGS

These and other aspects of the present invention will now be described in more detail, with reference to the appended drawings showing embodiments of the invention, of which:
Fig. 1 shows a cross section of a through hole in unplated PCB substrate according to the present invention.
Fig. 2 shows a cross section of through holes in unplated PCB substrate according to the present invention.
Fig. 3 shows an unplated PCB substrate with through holes of different sizes according to the present invention.
Fig. 4 shows a plated PCB substrate with a conductive layer according to the present invention.
Fig. 5 shows a) Stack of 3 layers of impregnated cellulosic fibers; b) cured PCB substrate with flat surface; c) cured PCB substrate with curved surface.
Fig. 6 shows a) single layer PCB with PCB substrate (white) and conductive layer (black); b) double layer PCB, c) multi-layer PCB with 3 conductive layers; d) single layer PCB with blind and through hole; e) double layer PCB with through hole and 2 blind holes; f) multi-layer PCB with through holes and blind holes.
Fig. 7 shows a cross section of the substrate according to the present invention.
Fig. 8 shows a temperature diagram during the pressing step.

### DETAILED DESCRIPTION OF THE PRESENT INVENTION

The present invention will now be described hereinafter in more detail, with reference to the accompanying drawings, in which exemplifying embodiments of the present invention are shown. The present invention may, however, be embodied in many different forms and should not be construed as limited to the embodiments of the present invention set forth herein; rather, these embodiments of the present invention are provided by way of example so that this disclosure will convey the scope of the invention to those skilled in the art, provided that they fall within the scope of the appended claims. In the drawings, identical reference numerals denote the same or similar components having a same or similar function, unless specifically stated otherwise.

As mentioned above, the PCB substrate comprises cellulosic fibers having a length of maximum 10 mm. Cellulosic fibers are made with ethers or esters of cellulose, which can be obtained from the bark, wood or leaves of plants, or from other plant-based material. Cellulosic fibers may be derived from the conversion of wood into wood pulp. The length of each cellulosic fiber in the composite material may be same as or different from the length of the other cellulosic fibers. Indeed, it is conceivable that some of the cellulosic fibers may have a length being greater than 10 mm, but the amount of these fibers should be considered negligible. By the term "negligible" is, in line with the invention, understood as an amount below 0.01 wt%. Cellulosic fibers may be provided in any suitable form, such as sheets, rolls, batting or the like. The cellulosic fibers that may be used in the composite material for manufacturing the PCB substrate according to the present invention can be recycled cellulosic fibers, which offers the advantage of decreasing the cost of the PCB substrate and contributing to a circular economy. On the other hand, the cellulosic fibers may be virgin cellulosic fibers, which provides an increased tensile and/or flexural strength of the circuit board compared to when recycled cellulosic fibers are used. Further, it is conceivable that the cellulosic fibers is a mixture of recycled and virgin cellulosic fibers in a range of 0-100% virgin cellulosic fibers and 0-100% recycled cellulosic fibers respectively. The cellulosic fibers may comprise paper, e.g. softwood kraft paper, hardwood kraft paper, sulfite fibers, organosolv fibers, non-woven or combinations thereof. It is conceivable that the cellulosic fibers comprise from 50 to 90 wt% of the kraft paper. The paper may be provided in the form of sheets and/or in the form of continuous sheets, e.g. paper rolls.

The PCB substrate of the present invention comprises 60 to 90 wt% of the cellulosic fibers and 10 to 40 wt% of the binding agent. The PCB substrate may have an amount of biobased carbon of at least 80%, preferably at least 90%, more preferably at least 95%. The biobased carbon is derived in whole or in part from biomass resources. Biomass resources are organic materials that are available on a renewable or recurring basis such as crop residues, wood residues, grasses, and aquatic plants. On the contrary, non-biobased carbon is made entirely from petrochemical resources. The amount of biobased carbon referred to above is a measure of the amount of biobased carbon in the product as compared to the sum of biobased and petroleum-based carbon in the product. The term biobased carbon describes carbon of non-fossil origin and relates to the cellulosic fibers and/or binding agent and/or additives.

The PCB substrate according to the present invention further comprises the binding agent in form of a polyfurfuryl alcohol (PFA).

The PCB substrate may comprise additives such as a UV-agent, a conducting compound, a pigment, a hydrophobic substance, a softener, a hardener, a curing agent, or the like. In line with the invention, an acidic curing catalyst is used, e.g. an inorganic or organic acid. The additive may be added in order to increase chemical, fire and wear resistance, and/or to increase curing speed, thus maximizing production.

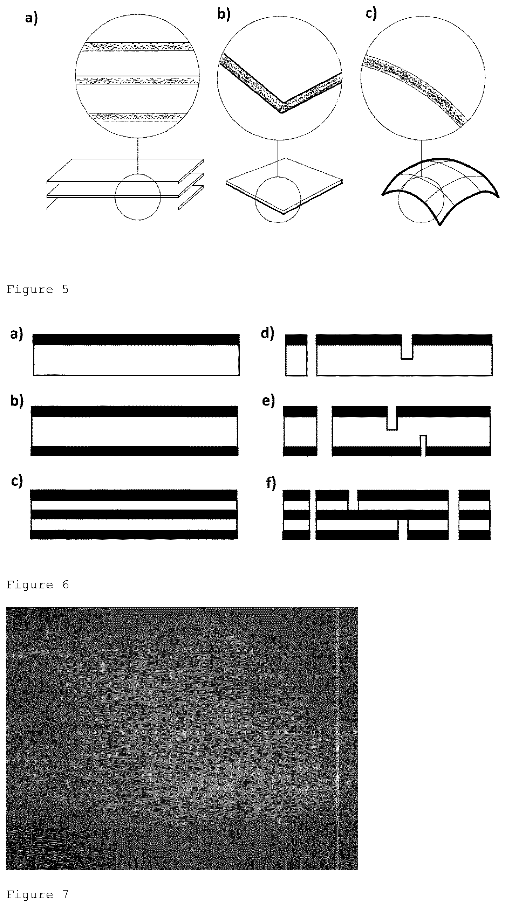

The prepreg material surprisingly shows advantageous floating properties during the curing step most likely attributed to the relatively short fibers in combination with the binding agent having a certain viscosity. It is conceivable to add e.g. max. 20% ethanol in the process to further improve the floating ability. The term floating shall be understood as a property of the cellulosic fibers to be able to move and fill cracks and tearing that may appear during manufacturing of PCB substrates. The floating properties enable the cellulosic fibers to adapt to the shape of a mold or tool during the manufacturing process. As shown in fig. 5, the floating properties enable the manufacturing of complex shapes, such as 3D shapes as well as flat surfaces and give control of micro surface structures, thus enabling tailored manufacturing of additional properties, such as surface properties, e.g. smooth and blank or matt and coarse surfaces. Fig. 5 illustrates how the single sheets of the prepregs are morphed into a single homogenous material of a flat or curved structure. Fig. 7 shows a cross section through the PCB substrate, it is not possible to distinguish the single layers of cellulosic fibers used during the manufacturing process. A property that is made possible due to the surprising floating effect of the short fibers in the manufacturing process according to the current invention.

One of the reasons for the high tensile and/or flexural strength of the PCB substrate of the present invention is believed to be a good adhesion between the fibers and the binding agent. The binding agent contributes to internal mechanical cross-linking of the fibers to each other, such that the fibers are caught and locked in each other, thus contributing to the tensile and/or flexural strength of the PCB substrate.

Another reason for the high tensile and/or flexural strength of the PCB substrate is the possibility to determine fiber orientation in the PCB substrate during manufacturing.

The cellulosic fibers may be randomly oriented or may be oriented such that the longitudinal extensions of the fibers are substantially parallel or substantially crisscrossed. To this end, the fibers may be positioned such that the longitudinal extension of the major portion of the fibers (the grain direction) is aligned in the same direction. This may be achieved by arranging one or more prepregs in a stack, in a certain direction. In particular, the at least one prepreg may be oriented such that the grain direction of the cellulosic fibers in the at least one prepregs are substantially parallel to the grain direction of the cellulosic fibers of the other of the at least one prepregs. It has been shown that the tensile and/or flexural strength in the direction being parallel to the grain direction is significantly higher compared to the tensile and/or flexural strength in the direction being perpendicular to the grain direction, e.g. as much as two times higher. Therefore, it is possible to design PCB substrates such that tensile and/or flexural and/or flexural strength is adapted to the intended use.

The cellulosic fibers of each of the at least one prepreg may also be oriented such that the cellulosic fibers are arranged in a crisscross shape. The at least one prepreg may then be arranged such that the grain direction of the cellulosic fibers of one of the at least one prepregs is perpendicular to the grain direction of the cellulosic fibers of the other of the at least one prepregs. The at least one prepreg may also be arranged such that the grain direction of the cellulosic fibers of one of the at least one prepregs is angled 0-90° to the grain direction of the cellulosic fibers of the other of the at least one prepregs, thereby realizing crisscross shapes with angles ranging from zero to right angle.

The PCB substrate may be manufactured such that it has at least one developable and/or non-developable surface portion. In the context of the present invention, a developable surface is a smooth surface with zero Gaussian curvature. A Gaussian curvature is defined as a product of two principal curvatures of a surface. Put differently, a developable surface is a non-flat surface that can be flattened onto a plane without distortion, i.e. it can be bent without stretching or compression. Conversely, it is a surface which can be made by transforming a plane by means of folding, bending, rolling, cutting and/or gluing. Examples of a developable surface are cylinders and cones. On the contrary, a non-developable surface is a surface with non-zero Gaussian curvature. A non-developable surface is thus a non-flat surface that cannot be flattened onto a plane without distortion. Most of surfaces in general are non-developable surfaces. Non-developable surfaces may be referred to as doubly curved surfaces. One of the most often-used non-developable surfaces is a sphere.

The PCB substrate according to the present invention exhibits high moisture resistance due to the nature of the binding agent possibly in combination with the production process. The short cellulosic fibers become impregnated by the binding agent in their entirety, and the PCB material becomes water-repellant to a larger extent compared to an article comprising long cellulosic fibers. The term "water-repellant" means hydrophobic and/or having a density that prevents water from penetrating the material. Since the short cellulosic fibers are easily movable within the composite material during manufacturing, the prepregs are enabled to merge during the pressing step, as the fibers may float and fill cracks and tearing that may appear during manufacturing of PCB substrates.

Further, it has been found that the PCB substrate according to the present invention is inflammable and self-extinguishable. According to a glow wire test performed, in accordance with IEC 60695-2-12:2021, the PCB substrate according to the invention when cured with PFA as a binding agent, passed the temperature test at 650° and 850° C. The PCB substrate according to the present invention is fire resistant according to STD 104-0001/ISO3795, UV resistant according to STD 423-0061, scratch resistant according to STD 423-0030, heat resistant according to Volvo STD 423-0055, impact resistant according to EN 13087 and tested VOC free according to Volvo STD 429-0003.

The PCB substrate of the present invention may be rigid. The term "rigid" in the context of the present invention is intended to mean as being deficient in or devoid of flexibility.

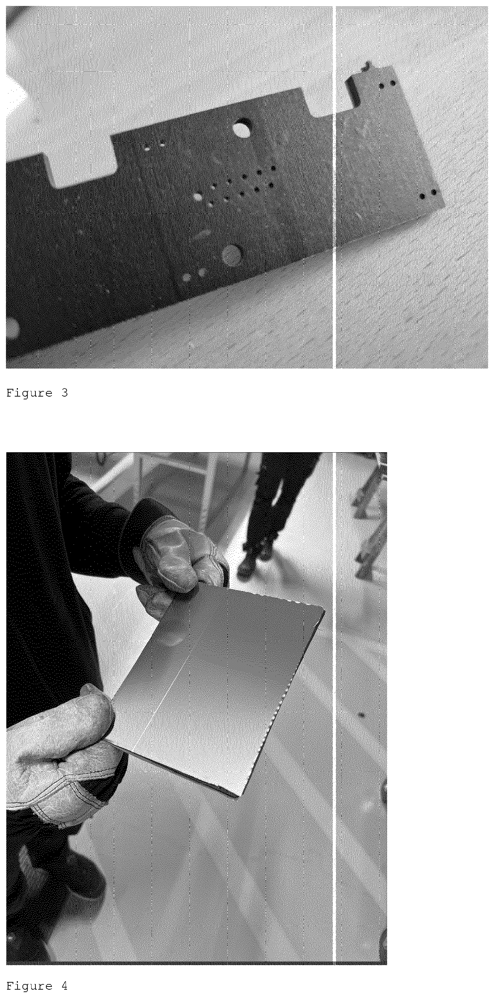

The PCB substrate may have an additional conductive layer on at least one of its top and bottom surface and or on both top and bottom surface, as shown in fig. 4. The conductive layer may be arranged directly on the top and/or bottom surface or on can be arranged on an additional insulating layer different from the PCB material, wherein the insulating layer is arranged on the top and/or bottom surface of the PCB substrate. The conductive layer may comprise e.g. copper, aluminum, iron, graphene, conductive polymers or a combination thereof.

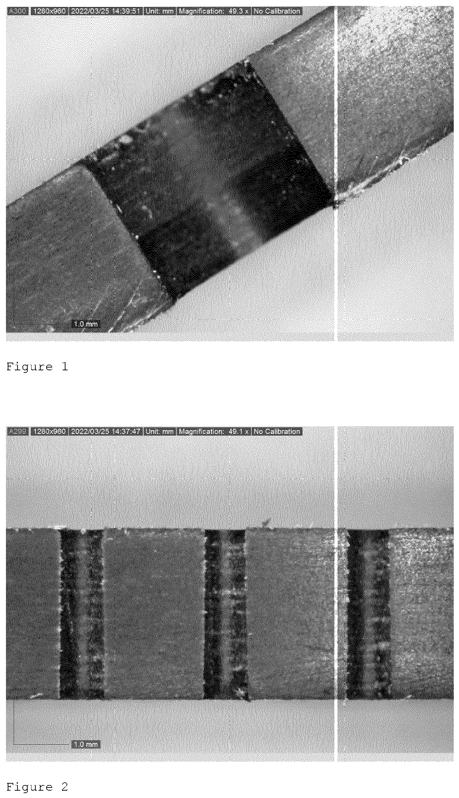

The PCB substrate may comprise cutouts as shown in fig. 1-3 and fig 6 d-f). The cutouts may be non-plated or plated and may at least be one of holes, slots, grooves, or other cavities. The holes, slots, or other cavities may be formed as through holes, slots, or other cavities, which in this context means that they are extending through the entire thickness of the PCB substrate, or may be formed as blind holes, slots, or other cavities which means that they do not go through the entire thickness of the PCB substrate and only extend a certain depth into the PCB substrate, wherein this depth is understood to have an extension smaller than the thickness of the PCB substrate. Holes may have a circular shape, and slots may be understood to have an elongated shape. Grooves may be understood as elongated indentations in the substrate that may have a v-shaped or u-shaped cross-section.

The method for manufacturing the PCB substrate according to the present invention may comprise cellulosic fibers, which may be provided in the form of a sheet, a continuous sheet or a batting; the cellulosic fibers have a length of maximum 10mm. The cellulosic fibers are impregnated with a mix of an acidic curing catalyst and a binding agent and pre-cured, thus a so called prepreg is obtained. A prepreg is understood to be an intermediate in the manufacturing process of the PCB substrate according to this invention. The prepreg is understood to be a cellulosic fibers impregnated with a catalyst and binding agent and heat treated in a pre-curing step. In the pre-curing step the impregnated cellulosic fibers are treated by applying heat in the range of 50 - 300°C. This treatment creates a viscous semi-solid structure, allowing the lay-up of layers, which forms a stack of a desired thickness that can be cured in a later step.

The stack of prepregs from which the PCB substrate of the present invention is manufactured may be in the form of at least one layer of precured cellulosic fibers being impregnated with the binding agent and additives. Further, the stack of prepregs from which the PCB substrate of the present invention is manufactured may comprise at least two layers, preferably at least three layers. Each of the layers preferably comprises the cellulosic fibers and the binding agent mix as described above.

The at least one prepreg can be arranged in a stack such that the cellulosic fibers of each of the at least one prepregs may be oriented such that the longitudinal extensions of the cellulosic fibers are substantially parallel. The at least one prepreg may also be arranged such that the longitudinal extensions of the cellulosic fibers of one of the at least one prepregs is perpendicular to the longitudinal extensions of the cellulosic fibers of the other of the at least one prepregs.

It has surprisingly been found that the although the stack of prepregs comprises at least one layer of impregnated fibers, the final PCB substrate according to the present invention is perceived as being made of a homogenous material. Without wishing to be bound by a theory, such an effected is believed to be achieved due to the length of the cellulosic fibers being below 10 **mm.** As mentioned above, the short hydrophilic cellulosic fibers are substantially completely impregnated by the binding agent. Further, when the stack of prepregs is subjected to a high pressure and elevated temperature and formed into the PCB substrate, almost no cracks are formed, since the cellulosic fibers may float and be rearranged without rupturing due to the short fiber length. The pressure may be at least 7 kg/cm2, preferably at least 25 kg/cm2, more preferably at least 30 kg/cm2 and the temperature may be at least 60°C, preferably at least 140°C, more preferably at least 150°C. In particular, the temperature may be from 148°C to 152°C. The time period may be at least 10 seconds, preferably at least one minute, more preferably at least two minutes.

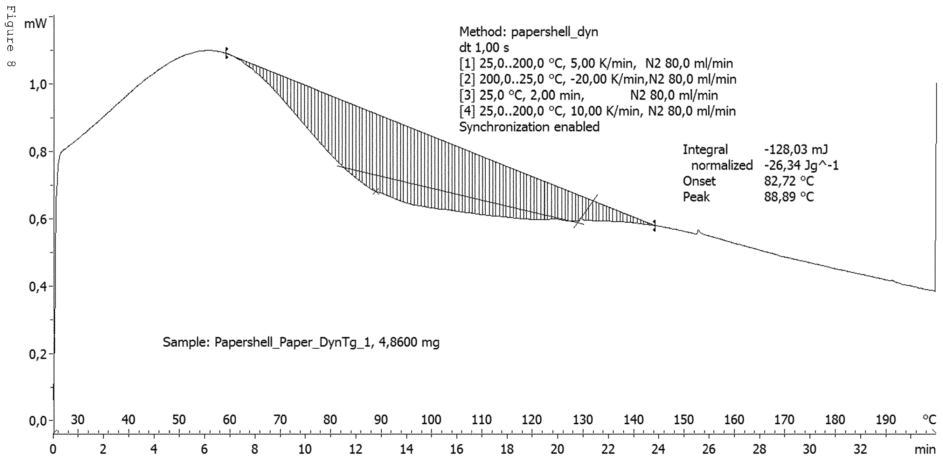

Figure 8 illustrates the behavior of cellulosic fibers during the pressing step. The cellulosic fibers in the prepreg start to exhibit floating properties at a temperature of approximately 60°C and the material cures at temperatures of approximately 150°C.

Further, even if a crack appears in one of the layers of the laminate, it may be filled by the cellulosic fibers from at least one of the adjacent layers of the laminate during the manufacturing process.

The PCB substrate according to the present invention may be manufactured by inflated bladder molding, injection molding or by heat pressure molding.

The prepreg and/or PCB substrate may be cut into a predetermined shape by cutting means, the cutting means may comprise scissor, saw, stamping, punching, cutter, e.g. water jet cutter, computer numerical control (CNC) router, laser cutter, or press. The prepreg and/or PCB substrate can be cut to small sizes with the aforementioned means, e.g. a minimum size of 1*1 mm in x-y direction may be achievable.

The method for manufacturing the PCB substrate may comprise the creation of cutouts or cavities with the help of cut-out creating means. The cut-out creating means may comprise drilling, milling, stamping, punching, water jet cutting, cutting with CNC router, laser cutting, engraving and/or scratching.

The method for manufacturing the PCB substrate may comprise the step of adding a conductive layer in the manufacturing process. The conductive layer may be added during the temperature and pressure treatment of the prepreg. At least one conductive layer may be added to the top or bottom surface of the stack when placed in the pressing tool. The pressing step is then performed with the conductive layer and the stack of prepregs in the pressing tool and the conductive layer adheres to the surface of the stack of prepregs. Test have shown that the adhesion is strong even without added adhesive. It is nevertheless conceivable, that an additional adhesive may be added. Conductive layer may be added to one or to two or more surfaces of the stack of prepregs during the manufacturing process thereby creating a PCB substrate that is coated with a conductive layer on one or two sides. When using copper as conductive material, good adhesion properties of the copper to the PCB substrate have been surprisingly noticed, even with the use of an additional adhesive, and might, without being bound to theory, be attributed to the manufacturing process of curing the stack of impregnated cellulosic fibers together with the conductive layer, in this case copper, in the pressing tool.

The produced PCB substrate with or without conductive layer is suitable to be used in the manufacturing of printed circuit boards (PCB), wherein the PCB substrate is the physical material that holds the traces and components of a PCB, it provides a structure that physically holds the circuit components and printed wires in place and provides electrical insulation between conductive parts.

The PCB substrates has insulating properties and is suitable to be used as a PCB substrate without the use of an insulating layer between the conductive layer and PCB substrate, but it is conceivable that an additional insulating layer may be provided. An electrical insulator is understood to be a material whose internal electric charge do not flow freely, and which therefore does not conduct an under the influence of an electric field.

The PCB substrate may be manufactured according to the needs of the PCB industry. The most common industrial standard PCB thicknesses are 0.78mm, 1.57mm and 2.36mm but thicker or thinner thicknesses can also be realized with the present invention.

Figure 6 illustrates 3 different types of PCBs that can be realized with the present inventive concept. Single layer PCBs can be manufactured with the PCB substrate according to the present invention. Single layer PCBs have a single conductive layer of conductive material (e.g. copper) on only one side of a non-conductive PCB substrate.

Double layer PCBs have one conductive layer on top of a non-conductive substrate and another conductive layer on the reverse side (top and bottom surface of the PCB substrate). The two conductive sides can be connected using e.g. plated holes, so called vias, in the substrate that connect to pads on both sides of the circuit board. Double layer PCBs can also be manufactured with the PCB substrate according to the present invention.

Multi-Layer PCBs are circuit boards that have three or more conductive layers (e.g. copper). The conductive layers are at the top and bottom, as well as at least one conductive layer sandwiched between non-conductive substrates. This arrangement of layers increases the surface area for wiring connections and also allows it to be more densely packed and as a result, it covers much less space. Multi-layer PCBs also be manufactured with the PCB substrate according to the present invention.

It is conceivable, that during the manufacturing process one or more layers of conductive material may be added on and/or between one or more layers of prepreg. In this case a layered structure of conductive material and prepreg will be cured, in which at least one layer of conductive material is sandwiched between at least two layers of prepreg, producing a PCB substrate in which at least one layer of conductive material is sandwiched between at least two layers of prepreg, as illustrated in fig. 6c).

To summarize, the present invention provides PCB substrates comprising cellulosic fibers, which is a natural, readily available, highly recyclable, and thus environmentally friendly and cost-efficient material. Another advantage of the present invention is that by-products from food and agriculture industry are used as a binding agent, which contributes to circular economy and is environmentally benign.

While the present invention has been illustrated in the appended drawings and the foregoing description, such illustration is to be considered illustrative or exemplifying and not restrictive; the present invention is not limited to the disclosed embodiments. Other variations to the disclosed embodiments can be understood and effected by those skilled in the art in practicing the claimed invention, from a study of the drawings, the disclosure, provided that they fall within the scope of the appended claims. In the appended claims, the word "comprising" does not exclude other elements or steps, and the indefinite article "a" or "an" does not exclude a plurality.

## Claims

1. A printed circuit board (PCB) substrate, comprising:
at least one top surface,
at least one bottom surface,
wherein the printed circuit board (PCB) substrate further comprises:
60 to 90 wt% of cellulosic fibers having a length of maximum 10mm, wherein the amount of cellulosic fibers having a length being greater than 10 mm is below 0.01 wt%;
an acidic curing catalyst and
10 to 40 wt% of a binding agent polyfurfuryl alcohol (PFA).

2. A PCB substrate according to claim 1, wherein said cellulosic fibers comprise from 0-100% virgin cellulosic fibers and 0-100% recycled cellulosic fibers.

3. A PCB substrate according to any of the preceding claims, wherein the at least one top surface and/or bottom surface has at least one developable and/or non-developable surface portion.

4. A PCB substrate according to any of the preceding claims, wherein said cellulosic fibers in the substrate are arranged substantially parallel, or wherein said cellulosic fibers in the substrate are arranged substantially crisscrossed, or wherein said cellulosic fibers in the substrate are arranged substantially random or arranged in a combination thereof.

5. A PCB substrate according to any of the preceding claims, wherein at least one conductive layer is adhered to the at least one top and/or bottom surface of said PCB substrate.

6. A PCB substrate according to any of the preceding claims, wherein the substrate comprises at least one cavity.

7. The PCB substrate according to any one of the preceding claims, wherein the amount of biobased carbon is at least 80%, preferably at least 90%, more preferably at least 95%.

8. The PCB substrate according to any one of the preceding claims, wherein the cellulosic fibers are provided in the form of paper.

9. The PCB substrate according to any one of the preceding claims, wherein said PCB substrate further comprises at least one conductive layer.

10. The PCB substrate according to any one of the preceding claims, wherein said PCB substrate further comprises at least one insulating layer.

11. A printed circuit board (PCB) comprising the substrate according to any of the preceding claims.

12. A PCB according to claim **11,** wherein the PCB is a single layer PCB, a double layer PCB or a multi-layer PCB.

## Patentansprüche

1. Leiterplatten- (PCB-) Substrat, Folgendes umfassend:
mindestens eine Oberseite,
mindestens eine Unterseite,
wobei das Leiterplatten- (PCB-) Substrat ferner Folgendes umfasst:
60 bis 90 Gew.-% Cellulosefasern mit einer Länge von maximal 10 mm, wobei die Menge der Cellulosefasern, die eine Länge von mehr als 10 mm aufweisen, unter 0,01 Gew.-% beträgt,
einen sauren Härtungskatalysator und
10 bis 40 Gew.-% eines Bindemittels Polyfurfurylalkohol (PFA).

2. PCB-Substrat nach Anspruch 1, wobei die Cellulosefasern von 0 bis 100 % frische Cellulosefasern und 0 bis 100 % recycelte Cellulosefasern umfassen.

3. PCB-Substrat nach einem der vorhergehenden Ansprüche, wobei die mindestens eine Oberseite und/oder Unterseite mindestens einen abwickelbaren und/oder nicht-abwickelbaren Oberflächenabschnitt aufweisen.

4. PCB-Substrat nach einem der vorhergehenden Ansprüche, wobei die Cellulosefasern in dem Substrat im Wesentlichen Parallel angeordnet sind oder wobei die Cellulosefasern in dem Substrat im Wesentlichen sich kreuzend angeordnet sind oder wobei die Cellulosefasern in dem Substrat im Wesentlichen willkürlich angeordnet sind oder in einer Kombination daraus angeordnet sind.

5. PCB-Substrat nach einem der vorhergehenden Ansprüche, wobei an die mindestens eine Oberseite und/oder Unterseite des PCB-Substrats mindestens eine leitende Schicht angeheftet ist.

6. PCB-Substrat nach einem der vorhergehenden Ansprüche, wobei das Substrat mindestens eine Kavität umfasst.

7. PCB-Substrat nach einem der vorhergehenden Ansprüche, wobei die Menge biobasierten Kohlenstoffs mindestens 80 % beträgt, vorzugsweise mindestens 90 %, bevorzugter mindestens 95 %.

8. PCB-Substrat nach einem der vorhergehenden Ansprüche, wobei die Cellulosefasern in Form von Papier bereitgestellt sind.

9. PCB-Substrat nach einem der vorhergehenden Ansprüche, wobei das PCB-Substrat ferner mindestens eine leitende Schicht umfasst.

10. PCB-Substrat nach einem der vorhergehenden Ansprüche, wobei das PCB-Substrat ferner mindestens eine isolierende Schicht umfasst.

11. Leiterplatte (PCB), das Substrat nach einem der vorhergehenden Ansprüche umfassend.

12. PCB nach Anspruch 11, wobei die PCB eine einschichtige PCB, eine doppelschichtige PCB oder eine mehrschichtige PCB ist.

## Revendications

1. Substrat de carte de circuit imprimé (PCB), comprenant :
au moins une surface supérieure,
au moins une surface inférieure,
le substrat de carte de circuit imprimé (PCB) comprenant en outre :
60 à 90 % en poids de fibres cellulosiques ayant une longueur maximale de 10 mm, la quantité de fibres cellulosiques ayant une longueur supérieure à 10 mm étant inférieure à 0,01 % en poids ;
un catalyseur de durcissement acide et
10 à 40 % en poids d'un liant alcool polyfurfurylique (PFA).

2. Substrat de PCB selon la revendication 1, dans lequel lesdites fibres cellulosiques comprennent 0 à 100 % de fibres cellulosiques vierges et 0 à 100 % de fibres cellulosiques recyclées.

3. Substrat de PCB selon l'une quelconque des revendications précédentes, dans lequel l'au moins une surface supérieure et/ou surface inférieure a au moins une partie de surface développable et/ou non développable.

4. Substrat de PCB selon l'une quelconque des revendications précédentes, dans lequel lesdites fibres cellulosiques du substrat sont agencées de manière sensiblement parallèle, ou lesdites fibres cellulosiques du substrat sont agencées de manière sensiblement croisée, ou lesdites fibres cellulosiques du substrat sont agencées de manière sensiblement aléatoire ou agencées en une combinaison de celles-ci.

5. Substrat de PCB selon l'une quelconque des revendications précédentes, dans lequel au moins une couche conductrice adhère à l'au moins une surface supérieure et/ou inférieure dudit substrat de PCB.

6. Substrat de PCB selon l'une quelconque des revendications précédentes, dans lequel le substrat comprend au moins une cavité.

7. Substrat de PCB selon l'une quelconque des revendications précédentes, dans lequel la quantité de carbone biosourcé est d'au moins 80 %, de préférence d'au moins 90 %, mieux encore d'au moins 95 %.

8. Substrat de PCB selon l'une quelconque des revendications précédentes, dans lequel les fibres cellulosiques sont fournies sous la forme de papier.

9. Substrat de PCB selon l'une quelconque des revendications précédentes, dans lequel ledit substrat de PCB comprend en outre au moins une couche conductrice.

10. Substrat de PCB selon l'une quelconque des revendications précédentes, dans lequel ledit substrat de PCB comprend en outre au moins une couche isolante.

11. Carte de circuit imprimé (PCB) comprenant le substrat selon l'une quelconque des revendications précédentes.

12. PCB selon la revendication 11, dans lequel le PCB est un PCB en couche unique, un PCB en couche double ou un PCB multicouche.
